# EUROPÄISCHE PATENTANMELDUNG

(11) **EP 1 921 020 A1**
(43) Veröffentlichungstag der Anmeldung: **14.05.2008**
(21) Anmeldenummer: 07117632.5
(22) Anmeldetag: 01.10.2007
(51) Int. Cl.: B65D 51/16, F16K 24/04

(54) **Druckausgleichelement für ein Gehäuse**

(30) Priorität: 10.11.2006 DE 102006053113
(71) Anmelder: ROBERT BOSCH GMBH, 70442 Stuttgart (DE)
(72) Erfinder: Geissler, Alexander, 07616 Buergel (DE); Hennel, Udo, 74321, Bietigheim-Bissingen (DE)

(57) **Zusammenfassung**

Die Erfindung betrifft ein Druckausgleichelement (1) für ein Gehäuse, insbesondere für ein Gehäuse das eine elektrische Schaltung aufnimmt, mit einer von einer Haltevorrichtung (13) gehaltenen semipermeablen Membran (12) und mindestens einem Dichtelement (2) zur Abdichtung gegenüber dem Gehäuse. Es ist vorgesehen, dass die Haltevorrichtung (13) von dem Dichtelement (2) gebildet ist.

## Beschreibung

Die Erfindung betrifft ein Druckausgleichelement für ein Gehäuse nach Oberbegriff des Anspruchs 1.

### Stand der Technik

Abgedichtete Gehäuse sind im Stand der Technik geläufig. Insbesondere werden sie in Anwendungen für elektronische Steuerungen in Fahrzeugen, beispielsweise für Steuergeräte, eingesetzt. Um den sehr weiten thermischen und barometrischen Einsatzbereich der Anwendungen gerecht zu werden, und aufgrund des Umstandes, dass durch Erwärmung und Abkühlung der eingebrachten elektronischen Schaltungen es zu Unter- und Überdrücken im Gehäuse kommt, die die Dichtungen und Verbindungsstellen belasten, bedürfen solcher abgedichteten Gehäuse eines Druckausgleichs. Der Druckausgleich wird im Stand der Technik durch semipermeable Membranen gewährleistet, die im Regelfall direkt auf das Gehäuse geklebt, geschweißt oder mit Kunststoff umspritzt werden. Um die semipermeablen Membranen in Verbindung mit einem solchen Gehäuse zu verwenden, bedürfen diese grundsätzlich eines mechanischen Schutzes, um eine Beschädigung und damit Undichtheit vermieden zu können. Aufgrund der unterschiedlichen Einbausituationen und Einbauanforderungen in den unterschiedlichen Applikationen ist der mechanische Schutz jeweils konstruktiv auf die jeweilige Einbausituation anzupassen, was erheblichen Aufwand verursacht. Weiter werden häufig zusätzliche Dichtelemente benötigt, beispielsweise O-Ringe, um die Dichtheit von als Zulieferteilen verwendete Membrane oder Schutzvorrichtungen zu gewährleisten.

### Offenbarung der Erfindung

Aufgabe der Erfindung ist es, ein Druckausgleichelement für ein abgedichtetes Gehäuse bereitzustellen, das die genannten Nachteile vermeidet, und im Bereich hoher mechanischer und fluidischer Belastung einen sicheren Druckausgleich bei gleichzeitiger Dichtheit gewährleistet.

Hierzu wird ein Druckausgleichelement für ein Gehäuse, insbesondere für ein Gehäuse, das eine elektronische Schaltung aufnimmt, vorgeschlagen, mit einer von einer Haltevorrichtung gehaltenen semipermeablen Membran und mindestens einem Dichtelement zur Abdichtung gegenüber dem Gehäuse. Es ist vorgesehen, dass die Haltevorrichtung von dem Dichtelement gebildet ist. Haltevorrichtung und Dichtelement sind folglich, zumindest im Wesentlichen, ein- und derselbe Gegenstand. Die semipermeable Membran wird demzufolge nicht mit unterschiedlichen Elementen, nämlich einer Haltevorrichtung und einem Dichtelement, verwendet, sondern das Dichtelement bildet selbst die Haltevorrichtung aus. Die semipermeable Membran ist letztlich am Dichtelement selbst angeordnet, wobei sie auf unterschiedliche Art und Weise aufgebaut werden kann, insbesondere kann sie aufgeklebt, eingelassen, aufgeschweißt oder verpresst sein.

In einer weiteren Ausführungsform ist vorgesehen, dass das Dichtelement einen Dichtsitz zum Einbringen in eine Öffnung des Gehäuses aufweist. Der Dichtsitz kann hierbei in jeder sinnvollen Ausführungsform, die die entsprechende Abdichtfunktion und Einbringung in das Gehäuse gewährleistet, vorliegen, beispielsweise im Wege des Formschlusses oder des Kraftschlusses, dass also das Dichtelement die Gehäusebohrung, in die es eingebracht wird, von Vorder- und Rückseite umgreift beziehungsweise in der Gehäusebohrung steckt, wozu im Regelfall ein leichtes Übermaß des Dichtelements gegenüber der Gehäuseöffnung erforderlich sein wird. Weiter ist ein Einbringen im Wege des Einklebens möglich, wobei die Fixierung und die Ausbildung des Dichtsitzes unter Zuhilfenahme eines Klebefilms, also einer die Klebung vermittelnden Substanz, bewirkt wird.

In einer weiteren bevorzugten Ausführungsform besteht das Dichtelement aus elastischem Material. Gerade beim Einbringen in eine Öffnung des Gehäuses im Wege des Formschlusses, also insbesondere durch ein auch ein Hintergreifen der Gehäuseöffnung umfassendes Halten des Dichtelements innerhalb der Gehäuseöffnung, als auch beim Einpressen mit Kraftschluss, sind die von dem elastischen Material auf die Gehäusewandung ausgeübten Kräfte maßgeblich. Ferner erleichtert die Ausführung aus elastischem Material das Einbringen in die Gehäuseöffnung, da das Dichtelement verformt werden kann.

In einer besonders bevorzugten Ausführungsform ist das elastische Material ein Elastomer.

In einer weiteren bevorzugten Ausführungsform ist das Dichtelement als Stopfen ausgebildet. Mit Stopfen ist im Wesentlichen jede stopfenförmige Ausführung gemeint, es ist hierbei nicht zwingend erforderlich, dass der Stopfen einen runden Querschnitt aufweist, wobei der runde Querschnitt aber vorteilhaft ist.

In einer weiteren bevorzugte Ausführungsform ist vorgesehen, dass das Dichtelement eine Ringnut oder Taille aufweist, die den Dichtsitz bildet. Die Ringnut beziehungsweise Taille wird so zu wählen sein, dass sie mit Spannung in die Gehäuseöffnung eingebracht wird. Gerade bei der Ausbildung des Dichtelements als Stopfen beziehungsweise aus elastischem Material, insbesondere als Stopfen aus elastischem Material, wird auf diese Weise eine hervorragende Abdichtung vorder- und rückseitig des Gehäuses durch Vermittlung der Eigennut beziehungsweise an der Gehäusewandung bei Verwendung einer Taille (Kraftschluss) bewirkt.

In einer besonders bevorzugten Ausführungsform ist vorgesehen, dass die semipermeable Membran von einem Schutzelement, das an dem Dichtelement direkt oder indirekt befestigt ist, überfangen ist. Beispielsweise kann das Schutzelement topfförmig ausgebildet und im Wesentlichen über das Dichtelement gestülpt sein. Die Befestigung des Schutzelements kann direkt oder indirekt erfolgen, also beispielsweise durch Klemmwirkung des Dichtelements innerhalb des Schutzelements, wobei beispielsweise das Dichtelement das topfförmig ausgebildete Schutzelement im Wege des Kraftschlusses hält, oder aber indirekt durch Verwendung von Befestigungsmitteln, beispielsweise Spitzen, Nasen oder ähnliches, die in das Dichtelement vom Schutzelement ausgehend eingreifen, oder durch Verschraubung oder Verklebung. Maßgeblich ist allein, dass das Schutzelement ausreichend sicher an dem Dichtelement befestigt ist.

In einer weiteren Ausführungsform ist zwischen der semipermeablen Membran und dem Schutzelement ein Zwischenraum ausgebildet. Der Zwischenraum wirkt als Kammer, die die Druckvermittlung zwischen der Umgebung und dem Gehäuseinnenraum bewirkt. Er erlaubt der Membran, sich im geringen Umfang aus ihrer Ruhelage herauszubewegen.

In einer bevorzugten Ausführungsform ist vorgesehen, dass der Zwischenraum mit der Umgebung kommunizierend verbunden ist. Dies kann beispielsweise durch Öffnungen, die vorzugsweise seitlich an dem Schutzelement angebracht sind (also nicht in unmittelbarer Gegenüberlage der Membran), erfolgen, sowie durch Öffnungen oder Abstandshalter zum Umfang des Dichtelements, die ein Kommunizieren zur Öffnungsseite des Schutzelements hin gestatten.

Weitere vorteilhafte Ausführungsformen ergeben sich aus den Unteransprüchen und aus Kombinationen derselben.

### Kurze Beschreibung der Zeichnungen

Die Erfindung wird nachstehend anhand von Zeichnungen näher erläutert. Es zeigen
- Figur 1: ein Druckausgleichelement aus Elastomer mit einem Schutzelement und
- Figur 2: ein Schutzelement, das durch Hinterschneidung auf dem Dichtelement befestigt ist.

### Ausführungsform(en) der Erfindung

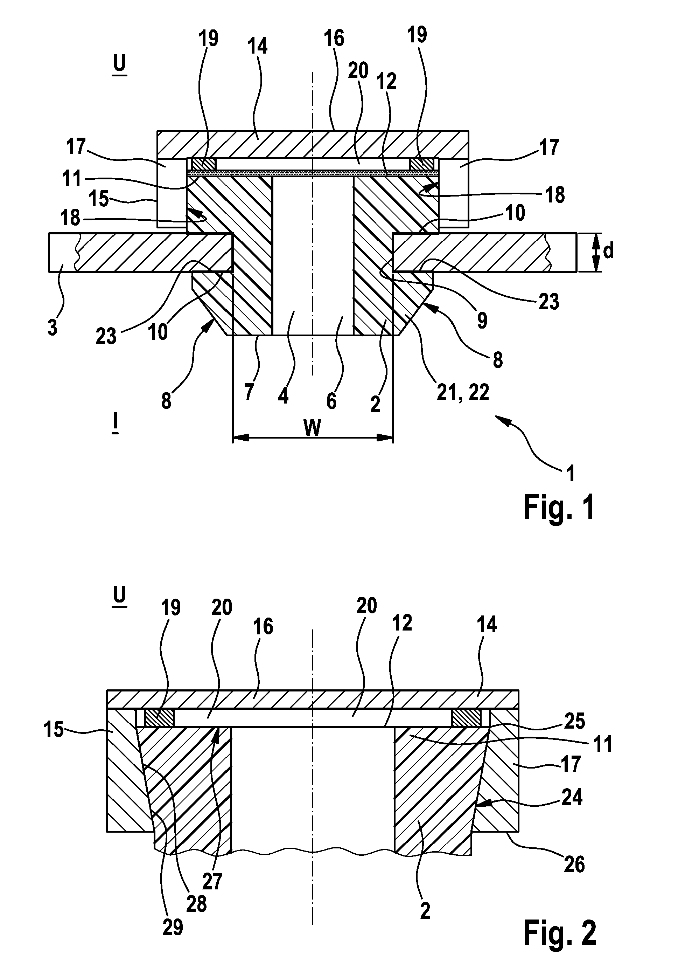

Figur 1 zeigt ein Druckausgleichelement 1 mit einem Dichtelement 2 zur Abdichtung gegenüber einer Gehäusewand 3, wobei das Dichtelement 2 eine durchgehende Ausnehmung 4 aufweist, also im Wesentlichen als Stopfen 5 mit einer Kernbohrung 6 ausgestaltet ist. Das Dichtelement 2 weist an einer Unterseite 7 eine Flankenverjüngung 8 auf, die dem leichteren Einbringen in eine Öffnung 9 der Gehäusewand 3 dient. Etwa mittig bezüglich seines Axialverlaufs weist der Stopfen 5 außenumfangsseitig eine Ringnut 10 auf, deren Abmessungen so gewählt sind, dass sie einerseits der lichten Weite w der Öffnung 9 der Gehäusewand 3 wie auch der Stärke d der Gehäusewand 3 entsprechen. Hierbei ist es vorteilhaft, wenn die Ringnut in Axialabmessung etwa schmäler ausgebildet ist, als die Stärke d der Gehäusewand dies erfordert, und in ihrem Bereich der Stopfen-Durchmesser etwas größer ist, als dies die Öffnung 9 der Gehäusewand 3 erfordert, also mithin ein leichtes Übermaß aufweist. Auf diese Weise wird Klemmsitz innerhalb der Öffnung 9 erreicht. An einer Oberseite 11 trägt das Dichtelement 2 vollflächig eine semipermeable Membran 12. Das Dichtelement 2 ist insoweit gleichzeitig Haltvorrichtung 13 für die semipermeable Membran 12. Die semipermeable Membran 12 überdeckt in jedem Fall die Ausnehmung 4 des Dichtelements 2. Die Oberseite 11 des Dichtelements 2 und die semipermeable Membran 12 werden von einem Schutzelement 14, das in der Art eines Topfes 15 ausgebildet ist, überfangen. Hierbei weist der Topf 15 einen Topfboden 16 und eine Topfseitenwand 17 auf, wobei die Topfseitenwand 17 in Berührlage mit einer Stopfenaußenwand 18 des Dichtelements 2 liegt, vorzugsweise einen Klemmsitz hierzu aufweist. Der Topf 15 überfängt die auf der Oberseite 11 des Dichtelements 2 angeordnete semipermeable Membran 12 vollständig, wobei der Topfboden 16 durch Abstandhalter 19 an einem direkten Aufliegen auf der semipermeablen Membran gehindert wird, sodass zwischen semipermeabler Membran 12 und dem Topfboden 16 ein Zwischenraum 20 gebildet wird. Die Topfseitenwand 17 weist, hier nicht dargestellt, Aussparungen auf, über die der Zwischenraum 20 mit einer Umgebung U des Druckausgleichelements 1 kommuniziert. Im Zwischenraum 20 herrscht demzufolge derselbe Luftdruck wie in der Umgebung U.

Zur Anbringung des Druckausgleichelements 1 in einem hier nicht dargestellten, abgedichteten Gehäuse, für das ausschnittsweise die Gehäusewand 3 wiedergegeben ist, und das einen Gehäuseinnenraum I aufweist wird das Dichtelement 2, das entweder zunächst nur mit der semipermeablen Membran 12 oder aber bereits sowohl mit der semipermeablen Membran 12 auf seiner Oberseite 11 als auch mit dem Schutzelement 14 vormontiert versehen ist, mittels der Flankenverjüngung 8 an seiner Unterseite 7 in die Öffnung 9 der Gehäusewand 3 eingebracht. Das Dichtelement 2 besteht aus einem elastischen Material 21, nämlich einem Elastomer 22. Das Dichtelement 2 verformt sich beim Einbringen in die Öffnung 9 demzufolge zumindest mit seinem zwischen Unterseite 7 und Ringnut 10 gelegenen Abschnitt. Insbesondere werden hierbei die Flankenverjüngungen 8 und der unterseitige Teil der Ringnut 10 zurückgedrängt, so dass das Dichtelement 2 bis zur Ringnut 10 in die Öffnung 9 der Gehäusewand 3 eingleitet. Nach dem Durchdringen der Öffnung 9 mit der Unterseite 7 des Dichtelements 2 kehrt dieser Abschnitt in die Ausgangslage zurück und bildet mit der Ringnut 10 einen Dichtsitz 23 aus, der das Dichtelement 2 innerhalb der Öffnung 9 der Gehäusewand 3 festhält und abdichtet. Der Gehäuseinnenraum I des abgedichteten Gehäuses wird demzufolge aufgrund der semipermeablen Membran 12 zur Umgebung U hin verschlossen; durch die Dichtheit des Dichtelements 2 ist ein Ausgleich zur Umgebung U über die Öffnung 9 der Gehäusewand 3 nicht mehr möglich. Das Schutzelement 14 liegt derart über der semipermeablen Membran 12, dass eine mechanische Beschädigung der semipermeablen Membran 12 durch äußere Einwirkungen nicht möglich ist. Die Druckvermittlung zwischen Umgebung U und dem Zwischenraum 20 erfolgt durch die (hier nicht dargestellten) Aussparungen der Topfseitenwand 17, so dass mechanische Einflüsse einerseits die semipermeablen Membranen 12 nicht direkt berühren können, und andererseits eventuelle Wasserbeaufschlagung auf der semipermeablen Membran 12, insbesondere im Zwischenraum 20, ohne Weiteres durch die nicht dargestellten Aussparungen durch die Topfseitenwand ablaufen können.

Figur 2 zeigt ausschnittsweise eine weitere Möglichkeit der Fixierung des Schutzelements 14 auf einem Dichtelement 2, das an seiner Oberseite 11 wiederum die semipermeable Membran 12 trägt, und wobei der Topfboden 16 über Abstandshalter 19 unter Ausbildung eines Zwischenraums 20 angeordnet ist. Die Topfseitenwand 17 weist hierzu eine Topfinnenwandung 24 auf, die sich, ausgehend von einem membranseitigen Ende 25 der Topfinnenwandung hin zu einem dem Topfboden 16 gegenüberliegenden Topfende 26 innenseitig verstärkt, mithin also der Innendruchmesser des Topfes 15, ausgehend vom membranseitigen Ende 25 nahe des Topfbodens 16 immer enger, die Topfseitenwand 17 indes immer stärker wird. Das Dichtelement 2 weist in Entsprechung hierzu eine Geometrie auf, die sich, ausgehend von einer Auflagefläche 27 der semipermeablen Membran 12 an immer weiter verjüngt, so dass das Dichtelement 2 im Durchmesser immer weiter abnimmt, je weiter es sich von der semipermeablen Membran 12 entfernt, bis zu dem Bereich, an dem das Topfende 26 erreicht ist. Hierdurch wird eine Hinterschneidung 28 gebildet, die einen Klemmsitz 29 des Topfes 15 auf dem Dichtelement 2 bewirkt. Auf diese Weise kann ohne besonderes Befestigungsvorrichtungen das Schutzelement 14 ohne Weiteres auf dem Dichtelement 2 sicher angebracht werden, wo es durch die Hinterschneidung 28 sicher festgeklemmt sitzt. Das Schutzelement 14 stellt in der Topfseitenwand 17 nach wie vor selbstverständlich die selben Aussparungen zur Druckvermittlung zwischen der Umgebung U und dem Zwischenraum 20 bereit, wie bereits vorstehend beschrieben.

## Patentansprüche

1. Druckausgleichelement für ein Gehäuse, insbesondere für ein Gehäuse, das eine elektrische Schaltung aufnimmt, mit einer von einer Haltevorrichtung gehaltenen semipermeablen Membran und mindestens einem Dichtelement zur Abdichtung gegenüber dem Gehäuse, **dadurch gekennzeichnet, dass** die Haltevorrichtung (13) von dem Dichtelement (2) gebildet ist.

2. Druckausgleichelement nach Anspruch 1, **dadurch gekennzeichnet, dass** das Dichtelement (2) einen Dichtsitz (23) zum Einbringen in eine Öffnung (9) des Gehäuses aufweist.

3. Druckausgleichelement nach einem der vorhergehenden Ansprüche, **dadurch gekennzeichnet, dass** das Dichtelement (2) aus elastischem Material (21) besteht.

4. Druckausgleichelement nach einem der vorhergehenden Ansprüche, **dadurch gekennzeichnet, dass** das elastische Material (21) ein Elastomer (22) ist.

5. Druckausgleichelement nach einem der vorhergehenden Ansprüche, **dadurch gekennzeichnet, dass** das Dichtelement (2) als Stopfen (5) ausgebildet ist.

6. Druckausgleichelement nach einem der vorhergehenden Ansprüche, **dadurch gekennzeichnet, dass** das Dichtelement (2) eine Ringnut (10) oder Taille aufweist, die den Dichtsitz (23) bildet.

7. Druckausgleichelement nach einem der vorhergehenden Ansprüche, **dadurch gekennzeichnet, dass** die semipermeable Membran (12) von einem Schutzelement (14), das am Dichtelement (2) direkt oder indirekt befestigt ist, überfangen ist.

8. Druckausgleichelement nach einem der vorhergehenden Ansprüche, **dadurch gekennzeichnet, dass** zwischen semipermeabler Membran (12) und dem Schutzelement (14) ein Zwischenraum (20) ausgebildet ist.

9. Druckausgleichelement nach einem der vorhergehenden Ansprüche, **dadurch gekennzeichnet, dass** der Zwischenraum (20) mit der Umgebung (U) kommunizierend verbunden ist.
